**Europäisches Patentamt**

**European Patent Office**

**Office européen des brevets**

(19)

(11) Veröffentlichungsnummer : **0 536 832 A1**

(12) **EUROPÄISCHE PATENTANMELDUNG**

(21) Anmeldenummer : **92202983.0**

(22) Anmeldetag : **29.09.92**

(51) Int. Cl.$^5$ : **H01L 41/09**

(30) Priorität : **05.10.91 DE 4133108**

(43) Veröffentlichungstag der Anmeldung :
**14.04.93 Patentblatt 93/15**

(84) Benannte Vertragsstaaten :
**DE FR GB**

(71) Anmelder : **Philips Patentverwaltung GmbH**
**Wendenstrasse 35 Postfach 10 51 49**
**W-2000 Hamburg 1 (DE)**
(84) **DE**

(71) Anmelder : **N.V. Philips' Gloeilampenfabrieken**
**Groenewoudseweg 1**
**NL-5621 BA Eindhoven (NL)**
(84) **FR GB**

(72) Erfinder : **Dibbern, Uwe, Dr., c/o Philips**
**Patentverwaltung**
**GmbH, Wendenstrasse 35**
**W-2000 Hamburg 1 (DE)**

(74) Vertreter : **Kupfermann, Fritz-Joachim,**
**Dipl.-Ing. et al**
**Philips Patentverwaltung GmbH**
**Wendenstrasse 35 Postfach 10 51 49**
**W-2000 Hamburg 1 (DE)**

(54) **Elektrischer Rotations- oder Linearmotor, dessen Läufer mittels Ultraschallschwingungen angetrieben wird.**

(57) Die Erfindung bezieht sich auf einen elektrischen Rotations- oder Linearmotor, dessen Läufer mit piezoelektrischen, Ultraschallschwingungen erzeugenden Mitteln angetrieben wird, wobei die Mittel mittels hochfrequenter Wechselspannungen in eine Schwingung versetzt werden und gegen eine Reibfläche des Läufers (9) gedrückt werden, wobei ein einzelnes Schwingelement (1) aus mit Elektroden (3a, 3b, 3c) belegten, geschichteten Streifen (a, b) piezoelektrischen Materials besteht und wobei zur Erzeugung einer kreisenden Bewegung eines die Reibfläche (9a) berührenden Schwingelementes (1, 1') die auf dieses einwirkenden Wechselspannungen mit zeitlich gegeneinander verschobenen Schwingungsmoden an die verschiedenen Streifen dieses Schwingelementes (1, 1') angelegt sind, wobei sich die Spannungen um mehr als das Vorzeichen unterscheiden.

FIG.1

EP 0 536 832 A1

EP 0 536 832 A1

Die Erfindung bezieht sich auf einen elektrischen Rotations- oder Linearmotor, dessen Läufer mit piezoelektrischen, Ultraschallschwingungen erzeugenden Mitteln angetrieben wird, wobei die Mittel mittels hochfrequenter Wechselspannungen in eine Schwingung versetzt werden und gegen eine Reibfläche des Läufers gedrückt werden, wobei ein einzelnes Schwingelement aus mit Elektroden belegten, geschichteten Streifen piezoelektrischen Materials besteht.

Ein piezoelektrischer Motor ist aus der US-PS 44 53 103 bekannt. Durch Anlegen einer hochfrequenten, elektrischen Wechselspannung an ein piezoelektrisches Schwingelement werden in diesem mechanische Schwingungen erregt, die über die Übertragungsstifte auf den Läufer übertragen werden. Die Amplitude der mechanischen Schwingungen beträgt wenige μm. Die Übertragungsstifte übertragen die mechanische Schwingung des Schwingelementes auf den Läufer, wobei jede Schwingung eine Weiterbewegung des Läufers um entsprechend wenige μm veranlaßt.

Aus der US-PS 43 39 682 ist es bekannt, einen piezoelektrischen Motor mittels zwei Aktuatoren in Form von Bimorphen anzutreiben. Diese Bimorphe bestehen aus zwei Streifen piezoelektrischen Materials, bei denen die Polarisation der einzelnen Streifen oder die angelegten Spannungen verschieden sind. Die zwei Bimorphe werden über Verstärker abwechselnd an Wechselspannungen angelegt. Ein Kontaktpunkt eines elastischen Verbindungselementes, das die freien Enden der Bimorphe verbindet, kommt in Kontakt mit dem Rotor des Motors und bewegt diesen.

Es ist Aufgabe der Erfindung, einen elektrischen Rotations- oder Linearmotor mit piezoelektrischer Anregung zu schaffen, der mit dem Einsatz eines als Aktuator dienenden Bimorphs auskommt.

Die gestellte Aufgabe ist erfindungsgemäß dadurch gelöst, daß zur Erzeugung einer kreisenden Bewegung eines die Reibfläche berührenden Schwingelementes die auf dieses einwirkenden Wechselspannungen mit zeitlich gegeneinander verschobenen Schwingungsmoden an die verschiedenen Streifen dieses Schwingelementes angelegt sind, wobei sich die Spannungen um mehr als das Vorzeichen unterscheiden.

Auf diese Art und Weise wird es möglich, mit Hilfe nur eines Bimorphs eine kreisförmige oder elliptische Bewegung zu erzielen, die zu einem Vorschub des vom Bimorph kontaktierten Rotors führt.

Nach einer weiteren Ausgestaltung der Erfindung ist vorgesehen, daß die Wechselspannung impulsförmig oder sinusförmig ausgebildet ist. Bei einer impulsförmigen Ansteuerung können die Impulse mit unterschiedlichen Amplituden und auch mit unterschiedlicher Impulsdauer sowie endlichen Anstiegszeiten eingesetzt werden.

Nach einer weiteren Ausgestaltung der Erfindung ist vorgesehen, daß der zeitliche Versatz der Schwingungsmoden etwa ein Viertel einer Periode beträgt. Bei einem Versatz von ca. 1/4 Periode ergeben sich besonders gute Betriebsergebnisse.

Nach einer weiteren Ausgestaltung der Erfindung ist vorgesehen, daß bei einer an einen Streifen angelegten sinusförmigen Wechselspannung

$$U_a = U_o.\sin \omega.t$$

die an den anderen Streifen angelegte Wechselspannung auf

$$U_b = U_o.\sin (\omega.t + \varnothing)$$

bemessen ist. Die sinusförmige Ansteuerung gehört zu der einfachsten Ansteuerart und wird deshalb bevorzugt ausgewählt werden.

Nach einer weiteren Ausgestaltung der Erfindung ist vorgesehen, daß bei einer an einen Streifen angelegten sinusförmigen Wechselspannung

$$U_a = U_o.\sin \omega.t$$

die an den anderen Streifen angelegte Wechselspannung auf

$$U_b = U_o.\sin (\omega.t + 90°) = U_o.\cos \omega.t$$

bemessen ist. Bei dieser Vorgabe der Wechselspannung ergeben sich besonders deutliche Auslenkungen des Aktuators in der x- und y-Ebene.

Nach einer weiteren Ausgestaltung der Erfindung ist vorgesehen, daß die piezoelektrischen Schichten des Schwingelementes quer zur Schichtung gleichsinnig polarisiert sind. Bei einer anderen Ausgestaltung der Erfindung ist vorgesehen, daß bei gegensinniger Polarisierung eine der Betriebsspannungen das entgegengesetzte Vorzeichen erhält.

Bei den vorbeschriebenen, als Aktuator wirkenden Bimorphen befindet sich der Kontaktpunkt zu dem Läufer des Motors jeweils im Bereich eines freien Aktuatorendes. Es ist aber auch möglich, daß das Schwingungselement an seinen beiden Enden gehalten ist und auf etwa halber Länge einen Kontaktpunkt für den Rotor des Motors aufweist. Auch hier beschreibt der Kontaktpunkt eine kreisförmige Bahn, längs der der Kontaktpunkt den Läufer mitnimmt.

In weiterer Ausgestalung der Erfindung ist dazu vorgesehen, daß an einem Schwingungselement, das an seinen beiden Enden gelenkig aufgehängt ist und das auf etwa halber Länge einen Kontaktpunkt für den Rotor des Motors aufweist, jeweils zwischen den Einspannungen und dem Kontaktpunkt paarweise verteilt Elektro-

2

denpaare angeordnet sind, die in den beiden Bereichen paarweise gleichsinnig an die Betriebsspannungen angelegt sind bei gegensinniger Polarisation der Streifen beiderseits des Kontaktpunktes. In weiterer Verfeinerung dieser Ausgestaltung ist vorgesehen, daß an einem Schwingelement, das an seinen beiden Enden starr eingespannt ist, beiderseits des Kontaktpunktes jeweils mehr als ein Elektrodenpaar angeordnet ist, wobei beiderseits des Kontaktpunktes die Streifenbereiche entgegengesetzte Polarisationen aufweisen. Eine in ihrer Wirkung verstärkte Ausgestaltung dieser Ausführungsform sieht vor, daß mehrere dieser Schwingelemente zu einem Kreis zusammengefügt sind, wobei jedes Schwingelement für sich allein wirkt, in der Kreisanordnung aber eine kompakte Wirkung anstrebt.

An sich ist es aus der JP-OS 61-1279 bekannt, einen Bimorph mit mehreren über seine Länge verteilten Elektrodenpaaren zu versehen. Es handelt sich dabei aber um eine Inchworm-Konstruktion, die nicht als Ultrallschallmotor angesprochen werden kann.

Die Erfindung wird anhand der Zeichnung näher erläutert. Es zeigen:

Fig. 1 einen als Aktuator wirkenden Bimorph, einseitig eingespannt im Schnitt, zusammen mit einem Ausschnitt eines von ihm angetriebenen Läufers, wobei der Kontaktpunkt am freien Ende des Bimorphs vorgesehen ist, zusammen mit einem im Schnitt dargestellten Läufer,

Fig. 2 den Motor nach Fig. 1 mit einem seitlich gelagerten Kontaktpunkt,

Fig. 3 die Bewegung des Kontaktpunktes des Bimorphes in einem Kreis während seiner Erregung mit den verschiedenen Wechselspannungen,

Fig. 4 einen an seinen beiden Enden gelenkig aufgehängten Bimorph mit einem Kontaktpunkt zum Läufer etwa auf halber Länge zwichen den beiden Einspannungen,

Fig. 5 einen an seinen beiden Enden eingespannten Bimorph mit einem Kontaktpunkt zum Läufer etwa auf halber Länge zwischen den beiden Einspannungen.

Fig. 6 eine Vervielfachung der Anordnung nach Fig. 5 zu einem geschlossenen Kreis gebogen,

Fig. 7 die Formen versetzter sinusförmiger Ansteuerspannungen,

Fig. 8 die Formen versetzter impulsförmiger Ansteuerspannungen.

Bei dem in der Zeichnung dargestellten piezoelektrischen Motor für einen Zweirichtungsantrieb geht es darum, mit einem Kontaktpunkt eines Bimorphs allein eine elliptische Bewegung auszuführen, die es möglich macht, während der Kontaktzeit zu einem Läufer in einer Bewegungsrichtung diesen in der gewünschten Richtung vorzuschieben und dann ohne Kontakt mit dem Läufer wieder zu dem Ausgangspunkt zurückzufahren.

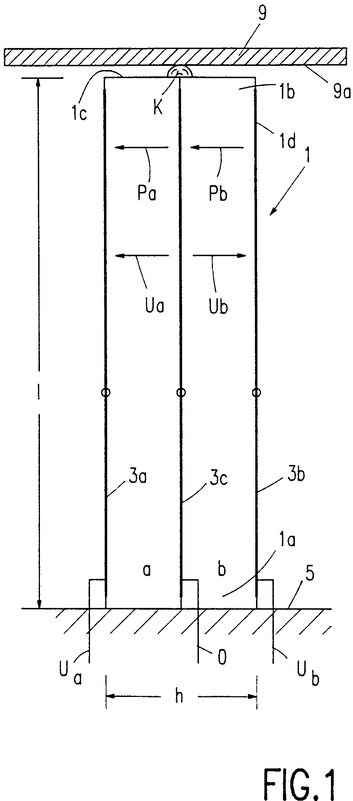

Fig. 1 zeigt einen Bimorph 1, der aus zwei piezoelektrischen Streifen a und b gebildet ist. Es sind drei Elektroden vorgesehen, und zwar Elektroden 3a und 3b, die die piezoelektrischen Streifen a und b auf ihrer Außenseite bedecken, und eine Elektrode 3c, die gemeinschaftlich die innenliegenden Oberflächen der piezoelektrischen Streifen kontaktiert. Der als Aktuator dienende Bimorph 1 ist an einem schematisch dargestellten Ständer 5 mit einem Ende 1a befestigt. Am anderen Längsende 1b des Bimorphs befindet sich an einer Stirnfläche 1c ein Kontaktpunkt K. Dieser Kontaktpunkt K kann mit der Reibfläche 9a eines nur im Ausschnitt dargestellten Läufer 9 in Kontakt kommen. Die Tiefe des Bimorphs ist mit h beziffert; seine axiale Länge mit l.

Wie Fig. 1 zeigt, können die beiden Streifen gleichsinnig polarisiert sein. Die Polarisationsrichtungen sind dabei mit $P_a$ und $P_b$ angegeben. An die Elektrode 3a ist eine Wechselspannung $U_a$ anlegbar. An die Elektrode 3b ist eine Wechselspannung $U_b$ anlegbar. Die Elektrode 3c wird als Bezugspunkt genommen.

Die angelegten Wechselspannungen sind wie folgt definiert:

$$U_a = U_o \cdot \sin \omega \cdot t$$
$$U_b = U_o \cdot \sin (\omega \cdot t + \varnothing) = U_o \cdot \cos \omega\, t,$$

wobei $\varnothing$ gleich 90 ° gesetzt ist.

Aus einer Analyse ergibt sich, daß sich bei Pa = Pb, wie gekennzeichnet, der Bimorph in Richtung y verlängert oder verkürzt, wenn $U_a$ und $U_b$ übereinstimmen, - unterschiedliche Vorzeichen dagegen zu einer Auslenkung in x-Richtung (Biegung) führen.

Es gilt im statischen Fall

$$\Delta y = d_{31} \frac{1}{h} (Ua + Ub)$$

$$\Delta x = \frac{3}{2} \cdot d_{31} \left(\frac{1}{h}\right)^2 (U_a - U_b)$$

wobei $d_{31}$ eine Materialkonstante ist.

Dies entspricht in Gleichung (2) der erwünschten elliptischen Bewegung. Das Verhältnis $\Delta Y/\Delta x$ kann über die Geometrie (Verhältnis Länge 1:Dicke h) und die Wahl von $\varphi$ eingestellt werden; dabei ist

$$\frac{\Delta x}{\Delta y} = \tan \varphi/_2 \cdot \frac{1}{h}$$

Die Auslenkungen sind also in dem gewählten xy-Koordinatensystem leicht zu separieren und durch die Summe bzw. Differenz von $U_a$ und $U_b$ gegeben. Gleiche Spannungen und damit gleiche Längenänderungen führen zu einer reinen Verlängerung (bzw. Verkürzung) des Bimorphs. Unterschiedliche Spannungen führen zu unterschiedlichen Längenänderungen und bewirken eine Krümmung.

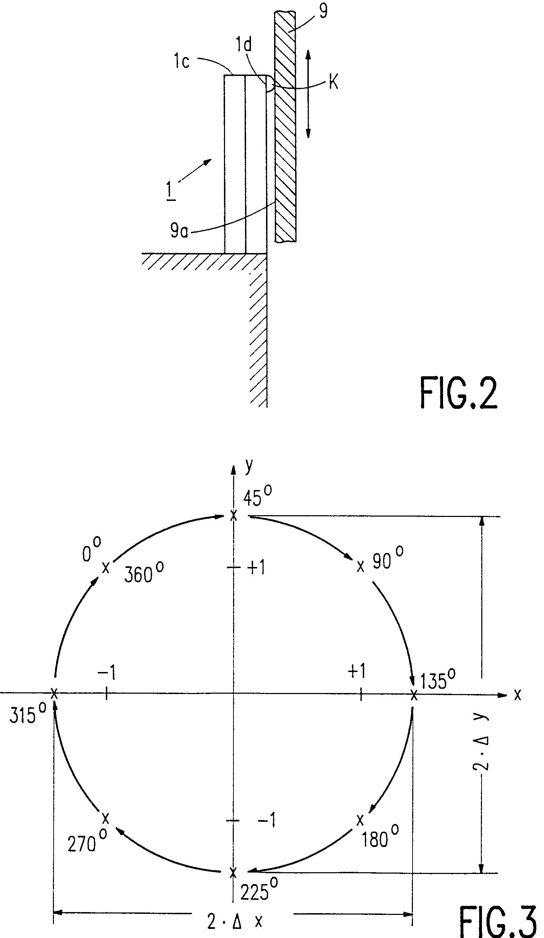

Im folgenden wird eine in Fig. 3 bildlich erläuterte Tabelle für Winkel mit einer Stufung von 45° zwischen 0° und 360° angegeben. Unter der Berücksichtigung, daß der Teiler $U_o$ in der Spaltenübersicht nicht angegeben ist, ergeben sich für Werte von $U_a/U_o$ und $U_b/U_o$ verschiedene Summen und Differenzen. Die Werte sind dabei auf eine Stelle hinter dem Komma begrenzt.

**TABELLE**

| Winkel | $U_a$ | $U_b$ | $U_a+U_b \sim \delta y$ | $U_a-U_b \sim \delta x$ |
|---|---|---|---|---|
| 0 ° | ±0.0 | +1.0 | +1.0 | -1.0 |
| 45 ° | +0.7 | +0.7 | +1.4 | ±0.0 |
| 90 ° | +1.0 | ±0.0 | +1.0 | +1.0 |
| 135 ° | +0.7 | -0.7 | ±0.0 | +1.4 |
| 180 ° | ±0.0 | -1.0 | -1.0 | +1.0 |
| 225 ° | -0.7 | -0.7 | -1.4 | ±0.0 |
| 270 ° | -1.0 | ±0.0 | -1.0 | -1.0 |
| 315 ° | -0.7 | +0.7 | ±0.0 | -1.4 |
| 360 ° | +0.0 | +1.0 | +1.0 | -1.0 |

Die Zahlen in den beiden letzten Spalten entsprechen bis auf die konstanten Faktoren $U_o.d_{31}.l/h$ bzw. $U_o.d_{31}.(l/h)^2$ den gesuchten Bewegungen $\delta y$ bzw. $\delta x$ in y- bzw. x-Richtung. Positive Werte von $\delta x$ bedeuten eine Bewegung nach rechts, und entsprechend bedeuten negative Werte von $\delta x$ eine Bewegung nach links. Positive Werte von $\delta y$ bedeuten eine Verlängerung des Bimorphs mit einer Bewegung in der Zeichnung nach oben, und negative Werte von $\delta y$ bedeuten eine Verkürzung in der y-Richtung und in der Zeichenebene nach unten.

In Fig. 3 sind die die beiden rechten Spalten mit ihren Winkeln als Parameter aufgetragen. Es ist klar zu erkennen, daß die Darstellung einen Kreisumlauf im Uhrzeigersinn ergibt. In der Praxis wird der Kontaktpunkt K des als Biegeaktuator wirkenden Bimorphs wegen l > h eine elliptische Bewegung machen. Der Läufer des Motors wird immer dann kontaktiert und durch Reibung mitgenommen, wenn $\delta y$, d. h. die Länge des Biegers groß wird, da dann ein Kontakt zum Läufer zustande kommt und ein Vorschub nach rechts erfolgt. Dies gilt auch, wenn man berücksichtigt, daß die Materialkonstante $d_{31}$ bei allen bekannten Piezokeramiken negativ ist, da dann an der x- und y-Achse gespiegelt wird.

Es ist ohne weiteres möglich, die Spannungen von $U_a$ und $U_b$ zu vertauschen, d. h. zu verpolen. Es bleibt $\delta y$ wegen der Addition $(U_a + U_b)$. Dagegen wechselt $\delta x$ wegen der Subtraktion $(U_a-U_b)$ sein Vorzeichen. Das bedeutet, daß der Kreis an der x-Achse gespiegelt wird. Das Startpunkt der Kurve (Winkel 0°) wandert um den dritten Quadranten. Damit wird die Kurve in entgegengesetzter Richtung durchlaufen. Der Läufer wird deshalb nach links verschoben, und die Bewegungsrichtung ändert ihr Vorzeichen.

Fig. 2 zeigt eine Variante des Antriebes nach Fig. 1. Der Kontaktpunkt K befindet sich dabei nicht an der Stirnfläche 1c, sondern am freien Ende 1b des Bimorphs im Bereich von seiner Seitenwand 1d. Auf diese Weise wird der Läufer 9 nicht quer zum Bimorph 1 bewegt, sondern in dessen Längsrichtung.

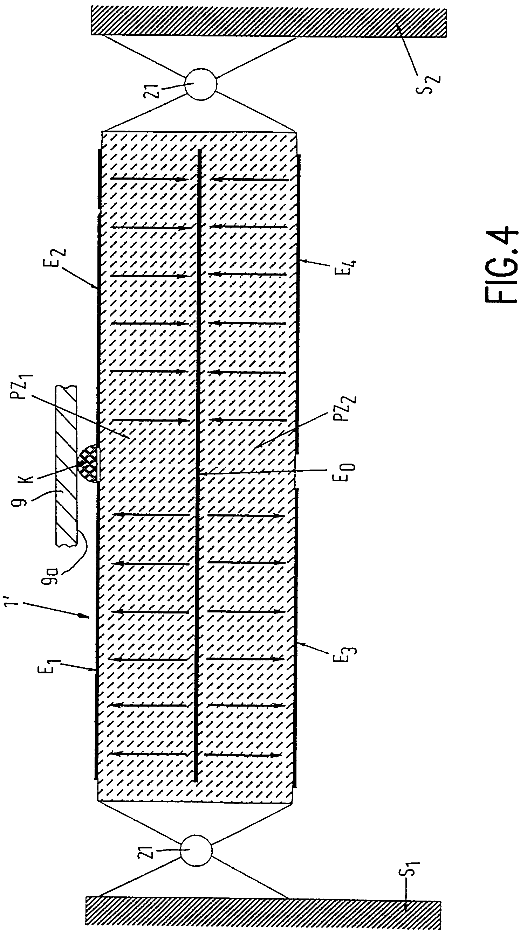

Die bisher dargestellten Grundstrukturen lassen sich variieren und erweitern durch Wiederholungen. Fig. 4 zeigt ein einfaches Beispiel: Ein Bimorph 1′, bestehend aus zwei piezoelektrischen Körpern $PZ_1$ und $PZ_2$, die fest miteinander verbunden sind. Die Trennfläche ist durch die Elektrode $E_0$ gebildet. $E_0$ ist im folgenden als Bezugselektrode anzusehen. In der Zeichnung ist weiterhin zu erkennen, daß der Bimorph über Gelenke 21 gelenkig an zwei festen Stützen $S_1$ bzw. $S_2$ befestigt ist. Die Polarisation des piezoelektrischen Werkstoffs ist durch die Pfeile dargestellt - links gehen die Pfeile von $E_0$ weg, während sie rechts auf $E_0$ weisen. Der Bimorph trägt vier Elektroden $E_1$ bis $E_4$, von denen die Elektroden $E_1$ und $E_3$ sowie $E_2$ und $E_4$ paarweise einander gegenüberliegen. Die Elektroden $E_1$ bis $E_4$ sind mit Spannungen $U_a$ und $U_b$ wie folgt verbunden:

$U_a$ mit $E_2$ und $E_3$

$U_b$ mit $E_1$ und $E_4$.

Wird das Element mit den oben angegebenen Spannungen angesteuert, macht der Kontaktpunkt K die erwünschte elliptische Bewegung und bewegt den angedeuteten Läufer in horizontaler Richtung. Vertauschen der beiden Spannungen kehrt die Bewegungsrichtung um.

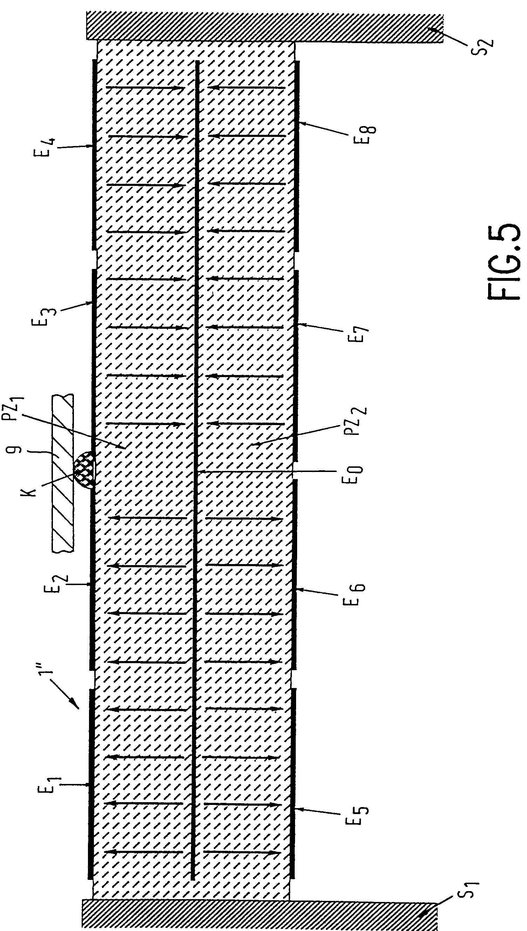

Fig. 5 zeigt eine weitere Ausgestaltung, bei der der Bimorph wiederum aus den Streifen $PZ_1$ und $PZ_2$ besteht, aber dieses Mal starr mit den beiden Stützen $S_1$ und $S_2$ verbunden ist. Die Richtung der Polarisation ist wieder angegeben. Der piezoelektrische Körper hat in der Mitte die gemeinsame Bezugselektrode $E_0$, auf die in diesen Beispielen alle Spannungen bezogen sind. Es sind weiter acht Elektroden $E_1$ bis $E_8$ gezeichnet. Dabei liegen $E_1$ und $E_5$, $E_2$ und $E_6$, $E_3$ und $E_7$, $E_4$ und $E_8$ paarweise einander gegenüber. Die Elektroden $E_1$ bis $E_8$ werden mit den Spannungen $U_a$ und $U_b$ folgendermaßen verbunden:

$U_a$ mit $E_1$, $E_3$, $E_6$ und $E_8$

$U_b$ mit $E_2$, $E_4$, $E_5$ und $E_7$.

Der Kontaktpunkt ist auch hier mit K bezeichnet; der horizontal bewegte Läufer ist mit 9 bezeichnet.

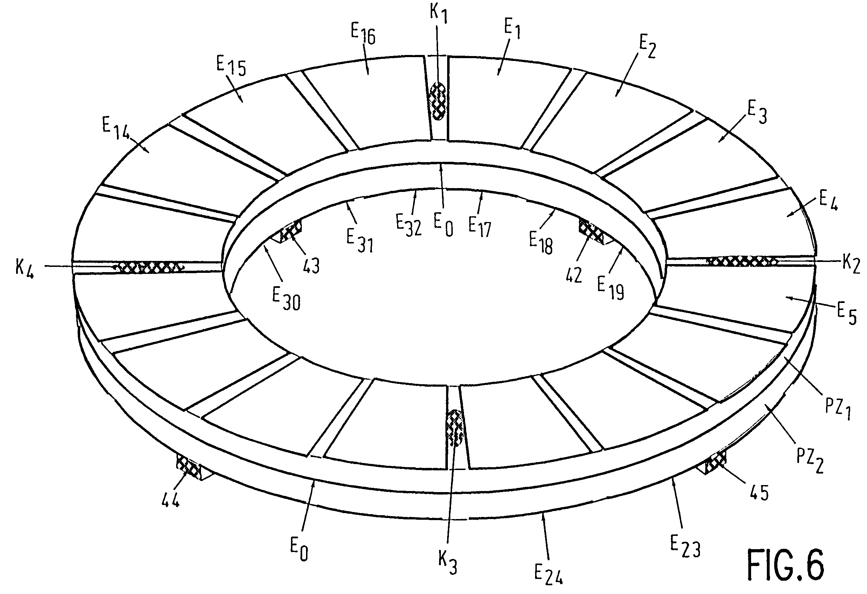

Eine weitere vorteilhafte Ausgestaltung ist ein in Fig. 6 dargestellter Rotationsmotor. Dieser kann als n-fache (in der Zeichnung: n = 4) Wiederholung der Anordnung von Fig. 5 angesehen werden, die zusätzlich zum Kreis gebogen wurde. Sie besteht aus zwei piezoelektrischen Ringen $PZ_1$ und $PZ_2$, die wieder über die Bezugselektrode $E_0$ fest miteinander verbunden sind. Oben und unten sind jeweils n.4 = 16 sektorförmige Elektroden $E_1$ bis $E_{16}$ sowie $E_{17}$ bis $E_{32}$ vorhanden. Die Anordnung wird starr über n (= 4) Stützen 42 bis 45 mit einem nicht gezeichneten Stator verbunden; diese Stützen befinden sich jeweils zwischen zwei Elektroden, z. B. $E_{18}/E_{19}$ oder $E_{22}/E_{23}$. Die Oberseite trägt n (= 4) Kontaktpunkte $K_1$ bis $K_4$, deren Orte (z. B. zwischen $E_{16}/E_1$ oder $E_4/E_5$) jeweils die Mitten zwischen zwei Stützen sind. Diese Kontaktpunke K bewegen den nicht gezeichneten Rotor um eine Achse, die mit der Achse der piezoelektrischen Ringe $PZ_1$ und $PZ_2$ übereinstimmt.

Die Vorzeichen der Polarisationen (bezogen wieder auf die Richtung zur Bezugselektrode $E_0$) können als Verallgemeinerung der Anordnung von Fig. 4 angesehen werden: Unter jeweils zwei nebeneinander liegenden Elektroden, z. B. $E_1$, $E_2$ sowie $E_{17}$, $E_{18}$ ist es gleich; eine Vorzeichenumkehr erfolgt sowohl bei den Kontaktpunkten K als auch den Stützen 42 bis 45.

Die Verbindungen von Elektroden mit den Spannungen sind ebenfalls eine Verallgemeinerung von Fig. 5:

$U_a 1$ liegt an $\quad E_1$, $E_3$, $E_5$, $E_7$, $E_9$, $E_{11}$, $E_{13}$, $E_{15}$

$E_{18}$, $E_{20}$, $E_{22}$ $E_{24}$, $E_{26}$, $E_{28}$, $E_{30}$, $E_{32}$

$U_b$ liegt an $\quad E_2$, $E_4$, $E_6$, $E_8$, $E_{10}$, $E_{12}$, $E_{14}$, $E_{16}$ $E_{17}$, $E_{19}$, $E_{21}$, $E_{23}$, $E_{25}$, $E_{27}$, $E_{29}$, $E_{31}$.

In einer weiteren Ausgestaltung ist es grundsätzlich denkbar, bei gleicher Polarisation und gleicher Elektrodenanordnung incl. Verbindung mit den Spannungsquellen die Zahl von Kontaktpunkten und Stützen zu verdoppeln: Dazu muß man auf der Oberseite erstens überall dort Kontaktpunkte anbringen, wo Fig. 6 schon Kontaktpunkte aufweist (z. B. zwischen $E_{16}/E_1$ oder $E_4/E_5$), zweitens aber zusätzlich dort, wo auf der Unterseite in Fig. 6 Stützen sind (z. B. zwischen $E_2/E_3$ oder $E_6/E_7$). Stützpunkte sind dann auf der Unterseite an jenen Elektrodenlücken vorzusehen, an denen oben keine Kontaktpunkte sind (z. B. zwischen $E_1/E_2$ oder $E_3/E_4$) - diese Stützen dürfen dann aber nicht starr, sondern müssen gelenkig mit dem Stator verbunden sein. Diese Ausgestaltung kann als Erweiterung der Anordnung nach Fig. 5 betrachtet werden.

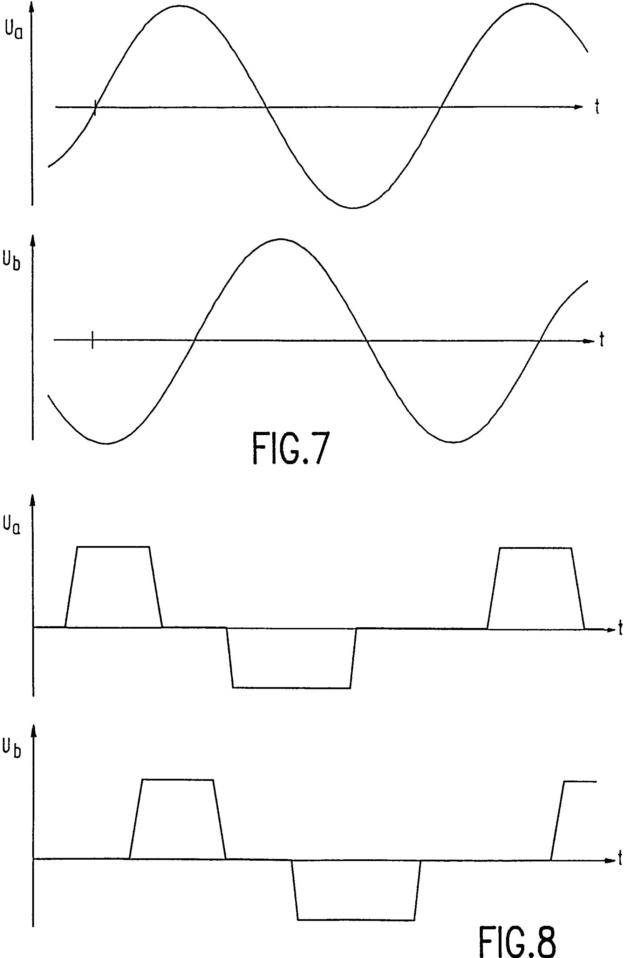

Fig. 7 zeigt sinusförmige Spannungen mit versetzten Schwingungsmoden, wie diese zum Einsatz kommen können.

Fig. 8 zeigt impulsförmige Spannungen mit versetzten Schwingungsmoden, die zum Ansteuern eingesetzt werden können.

## Patentansprüche

1. Elektrischer Rotations- oder Linearmotor, dessen Läufer mit piezoelektrischen, Ultraschallschwingungen erzeugenden Mitteln angetrieben wird, wobei die Mittel mittels hochfrequenter Wechselspannungen in eine Schwingung versetzt werden und gegen eine Reibfläche des Läufers (9) gedrückt werden, wobei ein einzelnes Schwingelement (1) aus mit Elektroden (3a, 3b, 3c) belegten, geschichteten Streifen (a, b) piezoelektrischen Materials besteht, dadurch gekennzeichnet, daß zur Erzeugung einer kreisenden Bewegung eines die Reibfläche (9a) berührenden Schwingelementes (1, 1') die auf dieses einwirkenden Wechselspannungen mit zeitlich gegeneinander verschobenen Schwingungsmoden an die verschiedenen Streifen dieses Schwingelementes (1, 1') angelegt sind, wobei sich die Spannungen um mehr als der Vorzeichen unterscheiden.

2. Elektrischer Rotations- oder Linearmotor nach Anspruch 1, dadurch,gekennzeichnet, daß die Wechselspannung impulsförmig oder sinusförmig ausgebildet ist.

3. Elektrischer Rotations- oder Linearmotor nach Anspruch 1 oder 2, dadurch gekennzeichnet, daß der zeitliche Versatz der Schwingungsmoden etwa ein Viertel einer Periode beträgt.

4. Elektrischer Rotations- oder Linearmotor nach Anspruch 1 oder 2, <u>dadurch gekennzeichnet</u>, daß bei einer an einen Streifen (a) angelegten sinusförmigen Wechselspannung

$$U_a = U_o \cdot \sin \omega \cdot t$$

die an den anderen Streifen (b) angelegte Wechselspannung auf

$$U_b = U_o \cdot \sin (\omega \cdot t + \varnothing)$$

bemessen ist.

5. Elektrischer Rotations- oder Linearmotor nach Anspruch 1, <u>dadurch gekennzeichnet</u>, daß bei einer an einen Streifen (a) angelegten Wechselspannung

$$U_a = U_o \cdot \sin \omega \cdot t$$

die an den anderen Streifen (b) angelegte Wechselspannung auf

$$U_b = U_o \cdot \sin (\omega \cdot t + 90°) = U_o \cdot \cos \omega \cdot t$$

bemessen ist.

6. Elektrischer Rotations- oder Linearmotor nach Anspruch 1, <u>dadurch gekennzeichnet</u>, daß die piezoelektrischen Schichten (a, b) des Schwingelements (1) quer zur Schichtung gleichsinnig polarisiert sind.

7. Elektrischer Rotations- oder Linearmotor nach Anspruch 1, <u>dadurch gekennzeichnet</u>, daß bei gegensinniger Polarisierung einer der Betriebsspannungen das entgegengesetzte Vorzeichen erhält.

8. Elektrischer Rotations- und Linearmotor nach Anspruch 1, <u>dadurch gekennzeichnet</u>, daß an einem Schwingungselement (1'), das an seinen beiden Enden gelenkig aufgehängt ist und das auf etwa halber Länge einen Kontaktpunkt (K) für den Rotor (9) des Motors aufweist, jeweils zwischen den Einspannungen und dem Kontaktpunkt (K) paarweise verteilt Elektrodenpaare ($E_1/E_3 - E_2/E_4$) angeordnet sind, die in den beiden Bereichen paarweise gleichsinnig an die Betriebsspannungen ($U_a$, $U_b$) angelegt sind bei gegensinniger Polarisation der Streifen ($PZ_1$ und $PZ_2$) beiderseits des Kontaktpunktes (Fig.4).

9. Elektrischer Rotations- und Linearmotor nach einem der Ansprüche 1 bis 5, <u>dadurch gekennzeichnet</u>, daß an einem Schwingelement (1''), das an seinen beiden Enden starr eingespannt ist, beiderseits des Kontaktpunktes (K) jeweils mehr als ein Elektrodenpaar ($E_1/E_5$, $E_2/E_6$; $E_3/E_7$; $E_4/E_8$) angeordnet ist, wobei beiderseits des Kontaktpunktes (K) die Streifenbereiche entgegengesetzte Polarisationen aufweisen (Fig. 5).

10. Elektrischer Rotations- und Linearmotor nach Anspruch 6, <u>dadurch gekennzeichnet</u>, daß mehrere Schwingelemente (1'') nach Fig. 5 und Anspruch 9 zu einem Kreis zusammengefügt sind (Fig. 6).

FIG.1

FIG.2

FIG.3

FIG.4

FIG.5

FIG.6

EP 0 536 832 A1

FIG.7

FIG.8

**Europäisches Patentamt**

# EUROPÄISCHER RECHERCHENBERICHT

Nummer der Anmeldung

EP 92 20 2983

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 384 455 (POLYTECHNIKA WARSZAFSKA)<br>* das ganze Dokument *<br>--- | 1,8-10 | H01L41/09 |
| A | EP-A-0 239 085 (KERNFORSCHUNGSANLAGE JÜLICH GESELLSCHAFT MIT BESCHRÄNKTER HAFTUNG)<br><br>----- | | |

| RECHERCHIERTE SACHGEBIETE (Int. Cl.5) |
|---|
| H01L |

Der vorliegende Recherchenbericht wurde für alle Patentansprüche erstellt

| Recherchenort | Abschlußdatum der Recherche | Prüfer |
|---|---|---|
| DEN HAAG | 06 JANUAR 1993 | PELSERS L. |